# EUROPEAN PATENT APPLICATION

(11) **EP 4 701 367 A1**
(43) Date of publication of application: **25.02.2026**
(21) Application number: 24832215.8
(22) Date of filing: 29.04.2024
(51) Int. Cl.: H10D 86/00, H01L 25/075, G01R 31/26, H01L 23/00, H10H 20/857

(54) **DISPLAY MODULE AND MANUFACTURING METHOD THEREFOR**

(30) Priority: 27.06.2023 KR 20230082870; 05.10.2023 KR 20230132666
(71) Applicant: Samsung Electronics Co., Ltd., Suwon-si, Gyeonggi-do 16677 (KR)
(72) Inventor: JUNG, Chulgyu, Suwon-si Gyeonggi-do 16677 (KR); LEE, Donghun, Suwon-si Gyeonggi-do 16677 (KR); KIM, Jiha, Suwon-si Gyeonggi-do 16677 (KR); JUNG, Youngki, Suwon-si Gyeonggi-do 16677 (KR)
(74) Representative: Gulde & Partner
(86) International application number: PCT/KR2024/005796
(87) International publication number: WO 2025/005430

(57) **Abstract**

A display module is disclosed. The disclosed display module comprises: a substrate including a first circuit layer including a TFT circuit, a second circuit layer for data transmission, and a third circuit layer for power and control signal transmission; a plurality of light-emitting diodes arranged on the first circuit layer; a plurality of first-side wirings electrically connecting a first circuit layer provided on the front surface of the substrate and a second circuit layer provided at the upper portion of the rear surface of the substrate; and a plurality of second-side wirings electrically connecting the first circuit layer and a third circuit layer, which is provided at the lower portion of the rear surface of the substrate, wherein the second circuit layer is film-shaped, and is attached to the rear surface of the substrate so as to be adjacent to the first end of the substrate, and the third circuit layer is film-shaped, and is attached to the rear surface of the substrate so as to be adjacent to the second end of the substrate.

## Description

### [TECHNICAL FIELD]

The present disclosure relates to a display module and a manufacturing method therefor.

### [BACKGROUND ART]

A display substrate may include a thin film transistor (TFT) layer including a plurality of TFTs and a plurality of light-emitting diodes mounted on the TFT layer. The plurality of light-emitting diodes may be operated in pixel or sub-pixel units to express various colors. An operation of each pixel or sub-pixel may be controlled by each of the plurality of TFTs. Each light-emitting diode may emit a different color, for example, red, green, or blue.

### [DISCLOSURE OF INVENTION]

### [SOLUTION TO PROBLEM]

According to an embodiment of the present disclosure, provided is a display module including: a substrate including a first circuit layer including a thin film transistor (TFT) circuit, a second circuit layer for data transmission, and a third circuit layer for power and control signal transmission; a plurality of light-emitting diodes arranged on the first circuit layer; a plurality of first-side wirings electrically connecting the first circuit layer disposed on a front surface of the substrate to the second circuit layer disposed on an upper portion of a rear surface of the substrate; and a plurality of second-side wirings electrically connecting the first circuit layer to the third circuit layer disposed on a lower portion of the rear surface of the substrate. The second circuit layer may be formed into a film shape, and is attached to the rear surface of the substrate to be adjacent to a first end of the substrate. The third circuit layer may be formed into a film shape, and is attached to the rear surface of the substrate to be adjacent to a second end of the substrate.

The second circuit layer may include a plurality of first connection pads electrically connected to one end of a plurality of first-side wirings. The third circuit layer may include the plurality of second connection pads electrically connected to one end of the plurality of second-side wirings.

The plurality of first-side wirings and the plurality of second-side wirings may each be made of silver (Ag) or copper (Cu). The plurality of first connection pads and the plurality of second connection pads may each be made of copper (Cu) or gold (Au).

Each of the plurality of first-side wirings and the plurality of second-side wirings may have a thickness of 1 µm or more. Each of the plurality of first connection pads and the plurality of second connection pads may have a thickness of 1 µm or more.

A distance between adjacent first connection pads among the plurality of first connection pads may be smaller than a distance between adjacent first-side wirings among the plurality of first-side wirings. A distance between adjacent second connection pads among the plurality of second connection pads may be smaller than a distance between adjacent second-side wirings among the plurality of second-side wirings.

The second circuit layer may further include a plurality of first test pads. The third circuit layer may further include a plurality of second test pads.

The plurality of first test pads and the plurality of second test pads may each be made of a low-resistance metal.

The plurality of first test pads and the plurality of second test pads may each be made of copper (Cu).

Each of the second circuit layer and the third circuit layer may include a flexible film layer, a first insulating layer laminated on the film layer, a metal layer laminated on the first insulating layer, and a second insulating layer laminated on the metal layer. The second insulating layer may include a plurality of openings disposed therein that expose a portion of the metal layer.

The portion of the metal layer may be a fan-out wiring section.

The portion of the metal layer may be a grounding point.

According to an embodiment of the present disclosure, provided is a display module including: a glass substrate; a first circuit layer disposed on a front surface of the glass substrate and including a thin film transistor (TFT) circuit; a second circuit layer disposed on an upper portion of a rear surface of the glass substrate and electrically connected to the first circuit layer by using a plurality of first-side wirings; a third circuit layer disposed on a lower portion of the rear surface of the glass substrate and electrically connected to the first circuit layer by using a plurality of second-side wirings; and a control substrate disposed on the rear surface of the glass substrate, electrically connected to the second circuit layer by a plurality of first flexible substrates, and electrically connected to the third circuit layer by a plurality of second flexible substrates. Each of the second circuit layer and the third circuit layer may be formed into a film shape and laminated on the glass substrate by using an adhesive layer applied to the glass substrate.

According to an embodiment of the present disclosure, provided is a manufacturing method for a display module, the method including: forming a first circuit layer including a thin film transistor (TFT) circuit on a first surface of a glass substrate; attaching a second circuit layer, formed into a film shape, to one side of a second surface of the glass substrate, and attaching the third circuit layer, formed into a film shape, to the other side of the second surface of the glass substrate; depositing a plurality of first-side wirings electrically connecting the first circuit layer to the second circuit layer, and depositing a plurality of second-side wirings electrically connecting the first circuit layer to the third circuit layer; transferring a plurality of light-emitting diodes onto the first circuit layer; testing the plurality of light-emitting diodes by using a plurality of test pads respectively disposed on the second circuit layer and the third circuit layer; and electrically connecting the second circuit layer and the third circuit layer to a control substrate.

### [BRIEF DESCRIPTION OF DRAWINGS]

FIG. 1 is a view illustrating a front surface of a display module according to at least one embodiment;
FIG. 2 is a view illustrating a rear surface of the display module according to at least one embodiment;
FIG. 3 is a cross-sectional side view of the display module according to at least one embodiment;
FIG. 4 is an enlarged view illustrating an example of fan-out wiring of a second circuit layer disposed on a substrate of the display module according to at least one embodiment;
FIG. 5 is a cross-sectional side view of the substrate of the display module according to at least one embodiment;
FIG. 6 is a bottom view illustrating an example of a connection between the connection terminal and side wiring of a rear circuit layer disposed on the substrate of the display module according to at least one embodiment;
FIG. 7 is a flowchart illustrating a manufacturing process of the display module according to at least one embodiment;
FIGS. 8, 9, 10, 11, and 12 are views illustrating examples of manufacturing the substrate of the display module according to one or more embodiments; and
FIG. 13 is a block diagram illustrating a display device according to at least one embodiment.

### [MODE FOR INVENTION]

Embodiments described in the present disclosure and configurations shown in the accompanying drawings illustrate only one preferred embodiment, and various modified embodiments may replace the embodiments and drawings of the present disclosure at the time of filing of this application.

Throughout the accompanying drawings of the present disclosure, the same reference numerals or symbols denote parts or components performing substantially the same functions.

Terms used in the specification are used to describe embodiments, and are not intended to restrict and/or limit the disclosed invention. A term of a single number may include its plural number unless explicitly indicated otherwise in the context. Terms such as "include" or "have" used in the specification specify the presence of features, numerals, steps, operations, components, parts mentioned in the specification, or combinations thereof, and do not preclude the presence or addition of one or more other features, numerals, steps, operations, components, parts, or combinations thereof.

Terms including ordinal numbers such as "first" and "second" used in the present disclosure may be used to describe various components. However, the components are not limited by these terms, and these terms are used only to distinguish one component from another. For example, a first component may be referred to as a second component, and similarly, the second component may be referred to as the first component without departing from the scope of the present disclosure. A term "and/or" includes a combination of a plurality of related items or any one of the plurality of related items.

Terms such as "front end", "rear end", "upper portion", "lower portion", "front surface", "rear surface", "upper surface", "lower surface", "upper end", "lower end", "one end", "the other end", "left", and "right" used in the present disclosure are defined based on the drawings. The shapes and positions of respective components are not limited by these terms.

Hereinafter, a display module according to at least one embodiment is described with reference to the accompanying drawings.

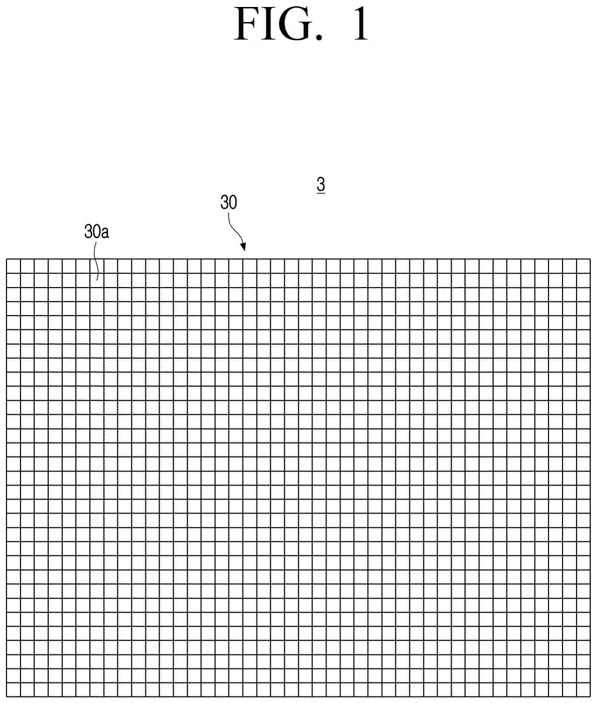

FIG. 1 is a plan view illustrating a display module according to at least one embodiment.

Referring to FIG. 1, a display module 3 may include a substrate 30 and a plurality of pixels disposed on a first surface of the substrate 30. For example, the plurality of pixels may include a plurality of light-emitting diodes 100 for displaying an image, each disposed in a pixel area 30a arranged in a matrix form on the substrate 30. The pixel area 30a may be a virtually partitioned rather than a physically partitioned area. One pixel may include the plurality of light-emitting diodes 100. In this case, one light-emitting diode 100 may be a sub-pixel.

The light-emitting diode 100 included in the display module 3 may be an inorganic light-emitting diode having a size of 100 µm or less. For example, the inorganic light-emitting diode may be a micro LED or a mini LED, and is not limited thereto. The inorganic light-emitting diode may have a fast response speed, low power, and high brightness.

The micro LED may be more efficient at converting electricity into photons than a liquid crystal display (LCD) or an organic light-emitting diode (OLED). The micro LED may also offer higher brightness per watt than the LCD or the OLED. The micro LED may produce the same brightness by using about half the energy of the LCD or the OLED exceeding 100 µm. The micro LED may offer high resolution, excellent color, contrast, and brightness, thereby accurately displaying a wide range of colors and delivering a clearer image even in an outdoor space, where brightness is higher than in an indoor space. The micro LED may be resistant to a burn-in phenomenon and generate less heat, thus ensuring a long lifespan without deformation.

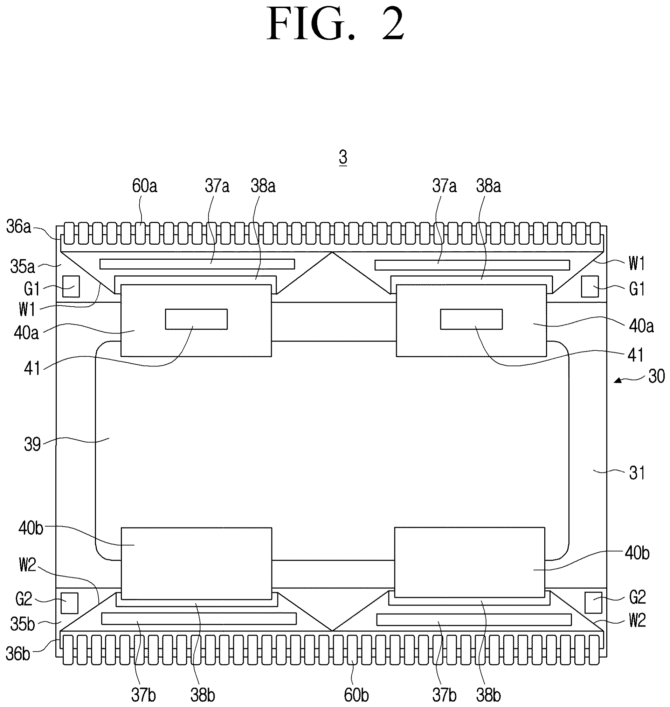

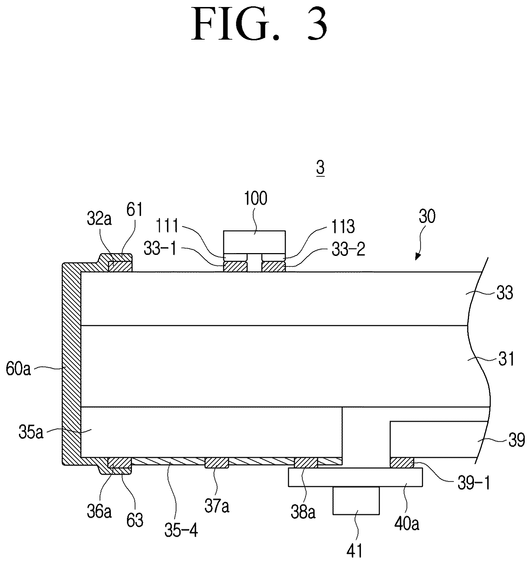

FIG. 2 is a view illustrating a rear surface of the display module according to at least one embodiment. FIG. 3 is a cross-sectional side view of the display module according to at least one embodiment.

Referring to FIG. 2 and FIG. 3, the substrate 30 may include a glass substrate 31, a first circuit layer 33 disposed on a front surface of the glass substrate 31, and a second circuit layer 35a and a third circuit layer 35b disposed on a rear surface of the glass substrate 31.

The glass substrate 31 may have the first circuit layer 33 disposed on the front surface thereof. The glass substrate 31 may have the second circuit layer 35a and the third circuit layer 35b disposed on the rear surface thereof.

Although the present disclosure describes the substrate 30 as including the glass substrate 31, the present disclosure is not limited thereto. Instead of the glass substrate 31, the substrate 30 may include a flexible synthetic resin substrate (e.g., polyimide (PI), polyethylene terephthalate (PET), polyethersulfone (PES), polyethylene naphthalate (PEN), or polycarbonate (PC)) or a ceramic substrate.

The glass substrate 31 may be formed into a quadrangle type. For example, the substrate may be formed into a rectangle or square type. The display module 3 may be formed into a quadrangle type based on the shape of the glass substrate 31.

The display module 3 may implement a large display device (e.g., a large format display (LFD)) by connecting a plurality of modules to each other horizontally, vertically, or in a grid arrangement. For example, the large display device may include a personal computer monitor, a high-resolution television, a signage (or digital signage), or an electronic display.

If used independently, the display module 3 may be applied to a wearable device, a portable device, or a handheld device.

The front surface of the glass substrate 31 may be divided into an active area and an inactive area. The active area may be the area occupied by the first circuit layer 33 within the entire front surface of the glass substrate 31. The inactive area may be the area excluding the active area within the entire first surface of the substrate.

An edge area of the glass substrate 31 refers to the outermost area of the glass substrate. For example, the edge area of the glass substrate 31 may include a first edge area and a second edge area. The first edge area may include an upper edge of the glass substrate 31, the front surface of the glass substrate 31 adjacent to the upper edge of the glass substrate 31, and an upper area of the rear surface. The second edge area may include a lower edge of the glass substrate 31, the front surface of the glass substrate 31 adjacent to the lower edge of the glass substrate 31, and a lower area of the rear surface.

The first edge area of the glass substrate 31 may have a plurality of first-side wirings 60a disposed therein and electrically connecting the first circuit layer 33 disposed on the front surface of the glass substrate 31 to the second circuit layer 35a disposed on an upper portion of the rear surface of the glass substrate 31. The second edge area of the glass substrate 31 may have a plurality of second-side wirings 60b disposed therein and electrically connecting the first circuit layer 33 disposed on the front surface of the glass substrate 31 to the third circuit layer 35b disposed on a lower portion of the rear surface of the glass substrate 31.

The first circuit layer 33 may include a plurality of TFT circuits electrically connected to the plurality of pixels. Each pixel may be driven by a corresponding TFT circuit.

The first circuit layer 33 may be formed on the front surface of the glass substrate 31 by using a photolithography method (for example, cleaning, deposition, photoresist application, exposure, development, etching, and photoresist stripping) to form the TFT circuit.

For example, TFT may include an amorphous silicon (a-Si) TFT, a low temperature polycrystalline silicon (LTPS) TFT, a low temperature polycrystalline oxide (LTPO) TFT, a hybrid oxide and polycrystalline silicon (HOP) TFT, a liquid crystalline polymer (LCP) TFT, or an organic TFT (OTFT). The TFT may also be applied by fabricating only a P-type (or N-type) metal oxide semiconductor field effect transistor (MOSFET) during a silicon (Si) wafer complementary metal oxide semiconductor (CMOS) process.

The first circuit layer 33 disposed on the front surface of the glass substrate 31 may be omitted. In this case, a plurality of micro integrated circuit (IC) chips functioning as the TFT circuits may be mounted on the front surface of the glass substrate 31. In this case, the plurality of micro ICs may be electrically connected to the plurality of light-emitting diodes arranged on the front surface of the glass substrate 31 via wiring.

The second circuit layer 35a may be disposed on the upper portion of the rear surface of the glass substrate 31. The second circuit layer 35a may be electrically connected to the plurality of first-side wirings 60a arranged at regular intervals along the first edge area of the glass substrate 31. The first-side wiring 60a may electrically connect the first circuit layer 33 disposed on the front surface of the glass substrate 31 to the second circuit layer 35a disposed on the rear surface of the glass substrate 31. The second circuit layer 35a may be electrically connected to a control substrate 39 by a plurality of first flexible substrates 40a.

The plurality of first flexible substrates 40a may transmit data signals provided from the control substrate 39 to the second circuit layer 35a. The data signals transmitted to the second circuit layer 35a may be transmitted to the first circuit layer 33 via the plurality of first-side wirings 60a.

The third circuit layer 35b may be disposed on the lower portion of the rear surface of the glass substrate 31. The third circuit layer 35b may be electrically connected to the plurality of second-side wirings 60b arranged at regular intervals along the second edge area of the glass substrate 31. The second-side wiring 60b may electrically connect the first circuit layer 33 disposed on the front surface of the glass substrate 31 to the third circuit layer 35b disposed on the rear surface of the glass substrate 31. The third circuit layer 35b may be electrically connected to the control substrate 39 by a plurality of second flexible substrates 40b.

The plurality of second flexible substrates 40b may supply power provided from the control substrate 39 to the third circuit layer 35b. Power provided to the third circuit layer 35b may be supplied to the first circuit layer 33 via the plurality of second-side wirings 60b. The plurality of second flexible substrates 40b may transmit the control signal provided from the control substrate 39 to the third circuit layer 35b. The control signal transmitted to the third circuit layer 35b may be transmitted to the first circuit layer 33 via the plurality of second-side wirings 60b.

The control substrate 39 may include a power supply circuit that supplies power to the first circuit layer 33, a data driver, a gate driver, and a timing controller that controls each driver.

Each of the second circuit layer 35a and the third circuit layer 35b may be formed into a film shape. In this case, the second circuit layer 35a and the third circuit layer 35b may be laminated on the upper and lower portions of the rear surface of the glass substrate 31, respectively. Therefore, the second circuit layer 35a and the third circuit layer 35b are disposed on the glass substrate 31 in a form different from that of the first circuit layer 33, which requires complex and numerous processes. Therefore, a manufacturing time of the substrate 30 may be significantly reduced or improved.

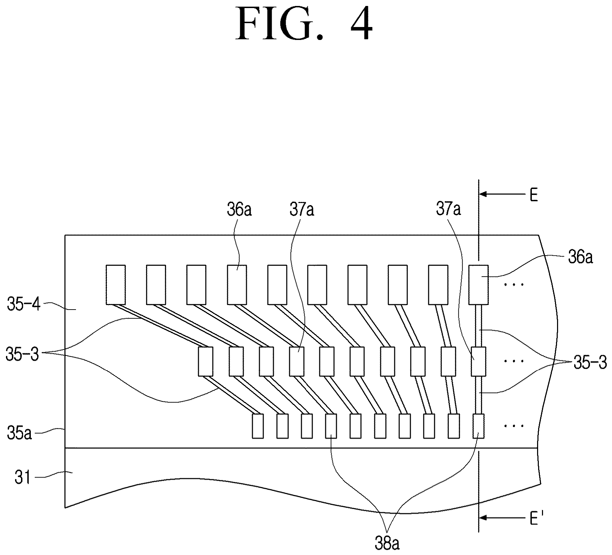

The second circuit layer 35a may include a first fan-out wiring section W1, and the third circuit layer 35b may include a second fan-out wiring section W2. In FIG. 2, a plurality of first connection pads 36a, a plurality of first test pads 37a, and a plurality of second connection pads 38a are schematically illustrated as respectively having rectangular shapes for convenience of description. The specific shapes of the plurality of first connection pads 36a, the plurality of first test pads 37a, and the plurality of second connection pads 38a may respectively have a plurality of pad shapes, as shown in FIG. 4.

The first fan-out wiring section W1 and the second fan-out wiring section W2 may have substantially the same structure, and only a structure of the first fan-out wiring section W1 is thus described below with reference to the drawings.

FIG. 4 is an enlarged view illustrating an example of the fan-out wiring section of the second circuit layer disposed on the substrate of the display module according to at least one embodiment.

Referring to FIG. 4, the first fan-out wiring section W1 disposed on the second circuit layer 35a may electrically connect the plurality of first connection pads 36a, the plurality of first test pads 37a, and the plurality of second connection pads 38a to one another. The first fan-out wiring section W1 may include a plurality of fan-out wirings 35-3 that sequentially connect one first connection pad 36a, one first test pad 37a, and one second connection pad 38a to one another. In this case, the number of fan-out wirings 35-3 may be equal to the number of first connection pads 36a.

The plurality of first connection pads 36a may be electrically connected to the plurality of first-side wirings 60a. The plurality of second connection pads 38a may be electrically connected to a plurality of connection pads disposed on the plurality of first flexible substrates 40a, respectively.

If the plurality of first test pads 37a are made of aluminum (Al), a current limit during testing of the substrate 30 may prevent a practical high-current operation, thus making aging impossible and causing voltage drop (IR drop). To address this issue, in the present disclosure, the plurality of first test pads 37a may be made of a low-resistance metal (for example, copper (Cu)).

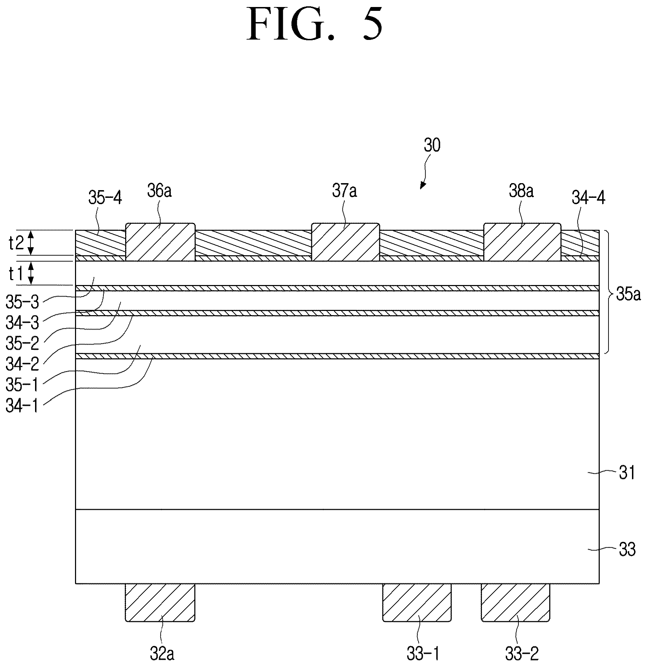

FIG. 5 is a cross-sectional side view of the substrate of the display module according to at least one embodiment.

Referring to FIG. 5, the substrate 30 may include the glass substrate 31, the first circuit layer 33 disposed on the front surface of the glass substrate 31, and the second circuit layer 35a and the third circuit layer and 35b respectively disposed on the rear surface of the glass substrate.

The first circuit layer 33 may include a TFT circuit formed by using the photolithography method. In addition to the TFT circuit, the first circuit layer 33 may further include a plurality of wirings and a plurality of protective layers.

The first circuit layer 33 may include a plurality of third connection pads 32a to which the plurality of first-side wirings 60a are connected. The first circuit layer 33 may include a plurality of substrate pads, such as substrate pad 33-1 and substrate pad 33-2, electrically connected to electrode pads, such as electrode pad 111 and electrode pad 113, (see FIG. 3) of the plurality of light-emitting diodes 100.

The second circuit layer 35a may be laminated as a plurality of layers to form a single film. The second circuit layer 35a may be laminated on the glass substrate 31 by using a first adhesive layer 34-1 applied to the rear surface of the glass substrate 31.

The second circuit layer 35a may include a film layer 35-1, a first insulating layer 35-2 laminated on the film layer 35-1 by using a second adhesive layer 34-2 applied to one surface of the film layer 35-1, a metal layer 35-3 laminated on the first insulating layer 35-2 by using a third adhesive layer 34-3 applied to one surface of the first insulating layer 35-2, and a second insulating layer 35-4 laminated on the metal layer 35-3 by using a fourth adhesive layer 34-4 applied to one surface of the metal layer 35-3.

The metal layer 35-3 may be used as the first fan-out wiring section W1. The metal layer 35-3 used as the first fan-out wiring section W1 may be mainly covered by the second insulating layer 35-4. In this case, the thicknesses of the metal layer 35-3 and the second insulating layer 35-4 may each be approximately 10 µm to 15 µm. Accordingly, the metal layer 35-3 and the second insulating layer 35-4 may each have a thickness greater than a thickness of the first circuit layer 33 formed by using the photolithography method (for example, approximately 0.7 µm or less). It is thus possible to protect or mitigate damage to the first fan-out wiring section W1 or delamination thereof that occurs due to an external impact (for example, a scratch) applied to the substrate 30 during transportation for manufacturing the display module 3.

In addition, each of the second circuit layer 35a and the third circuit layer 35b may be manufactured in the film shape separate from the glass substrate 31 and then laminated on the glass substrate 31 by using the first adhesive layer 34-1 instead of being formed on the glass substrate 31 by using the photolithography method like the first circuit layer 33, thereby reducing material costs, shortening a manufacturing process of the substrate 30, and maximizing yield.

A portion of the metal layer 35-3 may be used as a plurality of first grounding points G1 (see FIG. 2) to prevent electrostatic discharge (ESD) and secure a grounding area. In FIG. 2, the reference numeral G2 indicates a grounding point formed in a portion of the metal layer of the third circuit layer 35b.

The metal layer 35-3 may be exposed without being covered by the second insulating layer 35-4 at each portion thereof that is connected to the plurality of first connection pads 36a, the plurality of first test pads 37a, or the plurality of second connection pads 38a. That is, the second insulating layer 35-4 may include a plurality of openings for the plurality of first connection pads 36a, the plurality of first test pads 37a, and the plurality of second connection pads 38a.

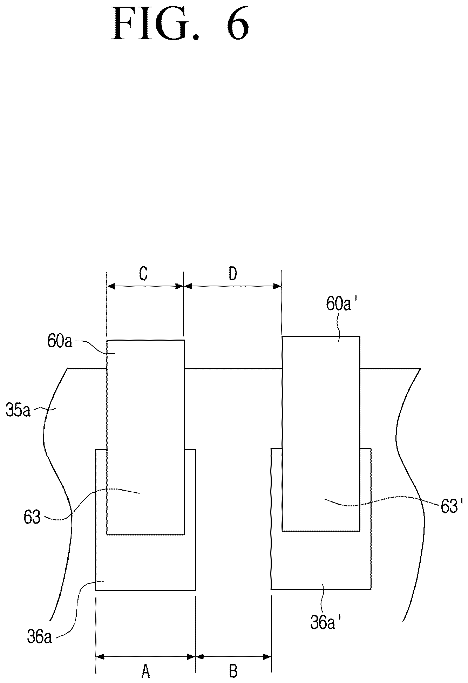

FIG. 6 is a bottom view illustrating an example of a connection between the connection terminal and side wiring of the rear circuit layer disposed on the substrate of the display module according to at least one embodiment.

Referring to FIG. 6, a width A of the first connection pad 36a, a distance B between adjacent first connection pads 36a, a width C of the first-side wiring 60a, and a distance D between adjacent first-side wirings 60a may be set based on materials of the first connection pad 36a and the first-side wiring 60a.

For example, the width A of the first connection pad 36a may be set to be equal to or similar to the distance D between the adjacent first-side wirings 60a based on a different thermal expansion coefficient between the material of the first connection pad 36a and the material of the first-side wiring 60a. The width C of the first-side wiring 60a may be set to be equal to or similar to the distance B between the adjacent first connection pads 36a. In this case, the width A of the first connection pad 36a may be smaller than the width C of the first-side wiring 60a. The distance B between the adjacent first connection pads 36a may be smaller than the distance D between the adjacent first-side wirings 60a. Accordingly, short-circuiting between the adjacent first connection pads 36a or between the adjacent first-side wirings 60a may be minimized or mitigated.

Each of the first-side wiring 60a and the first connection pad 36a may have a thickness of approximately 1 µm or more to minimize or mitigate separation of the first-side wiring 60a from the corresponding first connection pad 36a and the third connection pad 32a.

The first-side wiring 60a may be made of silver (Ag) or Cu. In this case, the first connection pad 36a and the third connection pad 32a may each be made of Cu or gold (Au) to improve an interfacial adhesion between the first-side wirings 60a.

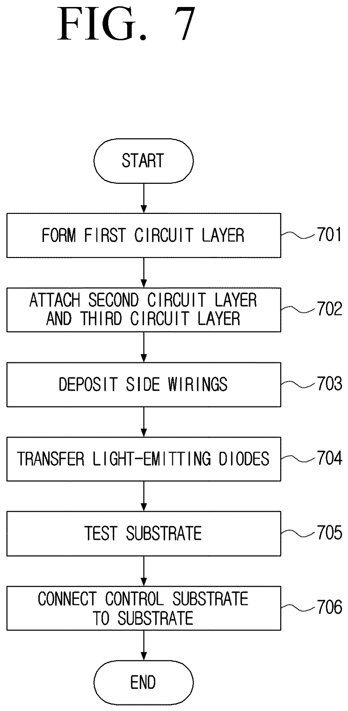

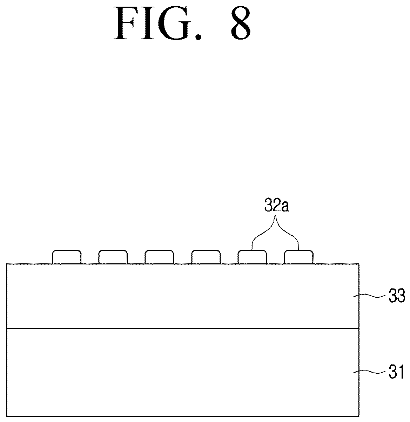

FIG. 7 is a flowchart illustrating a manufacturing process of the display module according to at least one embodiment. FIGS. 8, 9, 10, 11, and 12 are views illustrating examples of manufacturing the substrate of the display module according to one or more embodiments.

Referring to FIG. 8, the first circuit layer 33 including a TFT layer may be formed on the front surface of the glass substrate 31, for example, by using the photolithography method (at step 701 in FIG. 7).

The first circuit layer 33 may be formed to include the plurality of third connection pads 32a to be electrically connected to the plurality of first-side wirings 60a. In addition, the first circuit layer 33 may be formed to include a plurality of sixth connection pads (not shown) that are electrically connected to the plurality of second-side wirings 60b. In this case, the plurality of third connection pads 32a may be arranged in a row along an upper portion of the front surface of the glass substrate 31. The plurality of fourth connection pads may be arranged in a row along a lower portion of the front surface of the glass substrate 31.

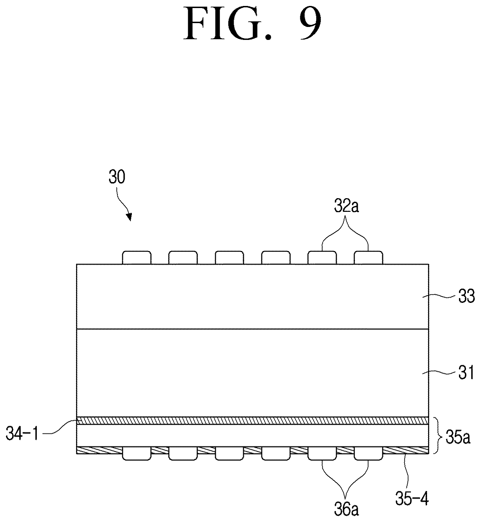

Referring to FIG. 9, the first adhesive layer 34-1 may be applied to each of the upper and lower portions of the rear surface of the glass substrate 31. Next, the second circuit layer 35a and the third circuit layer 35b, each formed into a flexible film shape, may be laminated on the upper and lower portions of the rear surface of the glass substrate 31, respectively (at step 702 in FIG. 7). In this way, the second circuit layer 35a and the third circuit layer 35b may be manufactured in advance before being laminated on the glass substrate 31.

The second circuit layer 35a may be formed to include the first fan-out wiring section W1 and the plurality of first grounding points G1. The first fan-out wiring section W1 may include the plurality of first connection pads 36a electrically connected to the plurality of first-side wirings 60a, the plurality of first test pads 37a, and the plurality of second connection pads 38a electrically connected to the plurality of first flexible substrates 40a.

The third circuit layer 35b may be formed to include the second fan-out wiring section W2 and the plurality of second grounding points G2. The second fan-out wiring section W2 may include a plurality of fourth connection pads 36b electrically connected to the plurality of second-side wirings 60b, a plurality of second test pads 37b, and a plurality of fifth connection pads 38b electrically connected to the plurality of second flexible substrates 40b. The plurality of second test pads 37b may be made of the same material as the plurality of first test pads 37a.

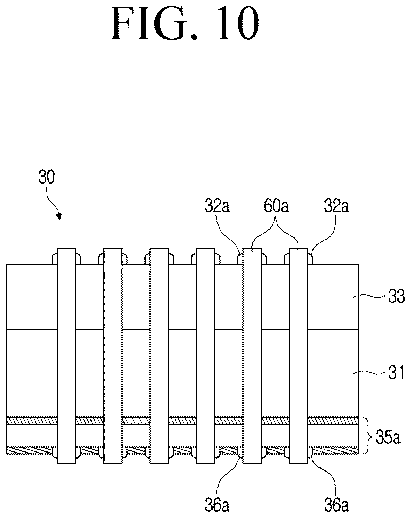

Referring to FIG. 10, the plurality of first-side wirings 60a may be deposited on the first edge area of the glass substrate 31, and the plurality of second-side wirings 60b may be deposited on the second edge area of the glass substrate 31 (at step 703 in FIG. 7).

The plurality of first-side wirings 60a may each have one end connected to the corresponding first connection pad 36a on the second circuit layer 35a and the other end connected to the third connection pad 32a on the first circuit layer 33.

The plurality of second-side wirings 60b may each have one end connected to the corresponding fourth connection pad 36b on the third circuit layer 35b and the other end connected to a sixth connection pad (not shown) on the first circuit layer 33.

The plurality of light-emitting diodes 100 may be transferred onto the first circuit layer 33 formed on the glass substrate 31 (at step 704 in FIG. 7).

The plurality of light-emitting diodes 100 may be micro LEDs. The plurality of light-emitting diodes 100 may be transferred onto the first circuit layer 33 by using a laser transferring method, a pick-and-place transferring method, a stamping transferring method, a rollable transferring method, or the like.

The first circuit layer 33 may include the plurality of substrate pads, such as substrate pad 33-1 and substrate pad 33-2, which are electrically and physically connected to the electrode pads, such as electrode pad 111 and electrode pad 113, of the plurality of light-emitting diodes 100.

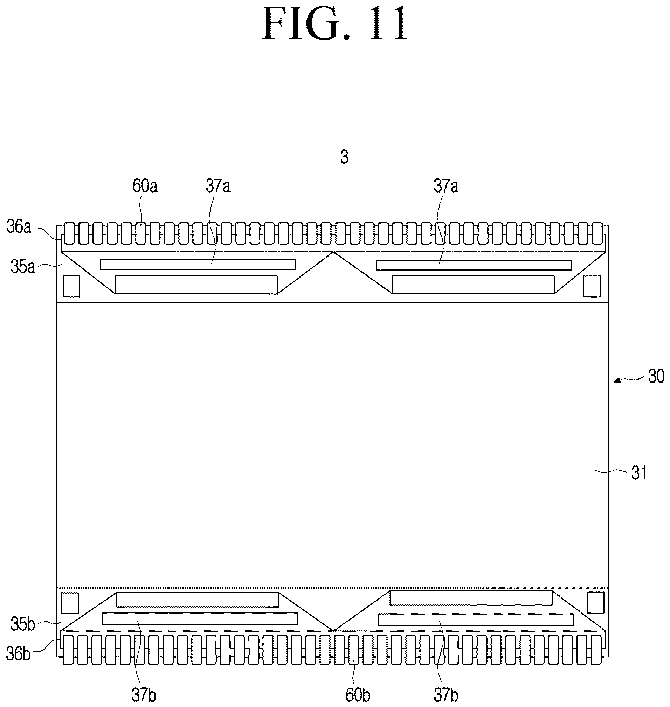

Referring to FIG. 11, the substrate 30 may be tested by using the plurality of first test pads 37a disposed on the second circuit layer 35a and the plurality of second test pads 37b disposed on the third circuit layer 35b (at step 705 in FIG. 7).

For example, the substrate 30 may be subjected to an electric die sorting (EDS) step for electrically testing the substrate 30 by applying voltages to the plurality of first test pads 37a and the plurality of second test pads 37b. In the EDS step, a pre-laser test may be performed to determine whether each of the light-emitting diodes 100 on the substrate 30 is normal or abnormal. A laser repair process may be performed to repair a repairable light-emitting diode among light-emitting diodes determined to be abnormal.

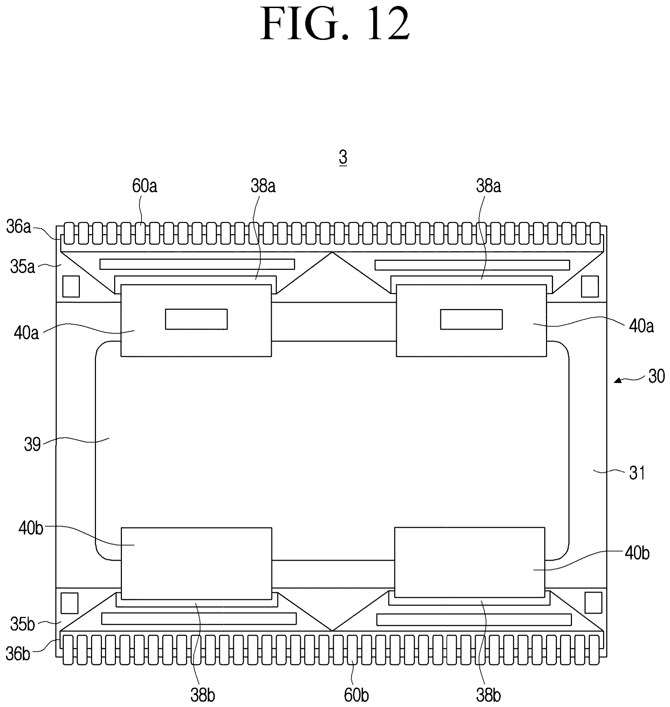

Referring to FIG. 12, the control substrate 39 may be connected to the substrate 30, which passes the testing (at step 706 in FIG. 7). In this case, the control substrate 39 may be electrically connected to the second circuit layer 35a via the plurality of first flexible substrates 40a.

The control substrate 39 may be electrically connected to the second circuit layer 35a via the plurality of first flexible substrates 40a. The plurality of first flexible substrates 40a may be chip-on-film (COF) type substrates, on each of which a chip 41 may be mounted. The control substrate 39 may be electrically connected to the third circuit layer 35b via the plurality of second flexible substrates 40b.

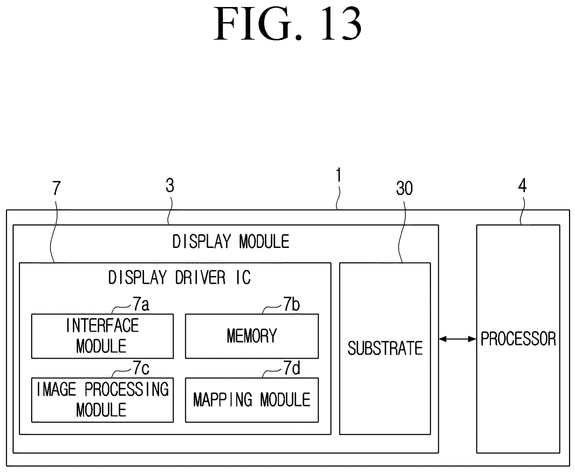

FIG. 13 is a block diagram illustrating a display device according to at least one embodiment.

Referring to FIG. 13, a display device 1 may include the display module 3 and a processor 4. The display module 3 may include the substrate 30 and a display driver IC 7 for controlling the substrate 30. In this case, the processor 4 may be mounted on the control substrate 39. The display driver IC 7 may be mounted on the control substrate 39 or each of the plurality of first flexible substrates 40a.

The processor 4 may be implemented as a digital signal processor (DSP), a microprocessor, a graphics-processing unit (GPU), an artificial intelligence (AI) processor, a neural processing unit (NPU), or a time controller (TCON) for processing a digital signal. However, the processor 4 is not limited thereto, and may include at least one of a central processing unit (CPU), a micro controller unit (MCU), a micro processing unit (MPU), a controller, an application processor (AP), a communication processor (CP), or an advanced Reduced Instruction Set Computer (RISC) machine (ARM) processor, or may be defined by a relevant term. In addition, the processor 4 may be implemented as a system-on-chip (SoC) or a large scale integration (LSI), having a processing algorithm embedded therein, or may be implemented as an application specific integrated circuit (ASIC) or a field programmable gate array (FPGA).

The processor 4 may control hardware or software components connected to the processor 4 by driving an operating system or an application program, and may perform various data processing and calculations. In addition, the processor 4 may load instructions or data received from at least one of other components into a volatile memory and process the same, and store various data in the non-volatile memory.

The display driver IC 7 may include an interface module 7a, a memory 7b (e.g., a buffer memory), an image processing module 7c, or a mapping module 7d. The display driver IC 7 may receive, for example, image data or image information including an image control signal corresponding to an instruction for controlling the image data, from another component of the display device 1 through the interface module 7a. For example, according to an embodiment, the display driver IC 7 may receive the image information from the processor 4 (e.g., a main processor (e.g., the application processor) or an auxiliary processor (e.g., a graphics processing unit) that operates independently of a function of the main processor).

The display driver IC 7 may communicate with a sensor module through the interface module 7a. In addition, the display driver IC 7 may store at least a portion of the received image information in the memory 7b, for example, on a frame basis. The image processing module 7c may perform pre-processing or post-processing (e.g., adjusting resolution, brightness, or size) on at least a portion of the image data, for example, based on characteristics of the image data or characteristics of the substrate 30. The mapping module 7d may generate a voltage value or a current value corresponding to the image data preprocessed or post-processed by using the image processing module 7c. According to an embodiment, the voltage value or current value may be generated based at least in part on characteristics of the pixels included in the substrate 30 (e.g., an arrangement of the pixels (e.g., an RGB stripe or a pentile structure), or a size of each sub-pixel). At least some pixels included in the substrate 30 may be driven, for example, based at least in part on the voltage value or the current value. Accordingly, visual information (e.g., text, an image, or an icon) corresponding to the image data may be displayed on the substrate 30.

The display driver IC 7 may transmit a driving signal (e.g., a driver driving signal or a gate driving signal) to the display module based on the image information received from the processor 4.

The display driver IC 7 may display an image based on the image signal received from the processor 4. For example, the display driver IC 7 may display the image by generating the driving signals for the plurality of sub-pixels based on the image signals received from the processor 4 and controlling light emission of the plurality of sub-pixels based on the driving signals.

According to at least one embodiment, the display module 3 may further include a touch circuit. The touch circuit may include a touch sensor and a touch sensor IC for controlling the same. The touch sensor IC may control the touch sensor to detect, for example, a touch input or a hovering input for a designated position of the substrate 30. For example, the touch sensor IC may detect the touch input or the hovering input by measuring a change in a signal (e.g., voltage, light intensity, resistance, or charge) for the designated position of the substrate 30. The touch sensor IC may provide information (e.g., position, area, pressure, or time) about the detected touch input or hovering input to the processor 4. According to an embodiment, at least a portion of the touch circuit (e.g., the touch sensor IC) may be included as a portion of the display driver IC 7, the substrate 30, or as a portion of another component (e.g., the auxiliary processor) disposed outside the display module 3.

According to at least one embodiment, a pixel driving method of the display module 3 may be an active matrix (AM) driving method or a passive matrix (PM) driving method.

According to at least one embodiment, the display device 1 may include the display module 3. The display module 3 may display various images. Here, the images may include still images and/or moving images. The display module 3 may display various images, such as broadcast content or multimedia content. In addition, the display module 3 may also display a user interface and icons.

According to at least one embodiment, the display module 3 may be installed in and applied to the wearable devices, the portable devices, the handheld devices, and various electronic products or electrical products requiring displays.

According to at least one embodiment, the display device 1 may include the plurality of display modules 3. The plurality of display modules 3 may be physically connected to each other to implement the large display (for example, a large format display). The large display may include the personal computer monitor, the high-definition television, the signage (or digital signage), or the electronic display by connecting the plurality of display modules to each other in the grid arrangement.

While the present disclosure has been shown and described above with reference to the various examples, it will be understood by those skilled in the art that various modifications in form and detail may be made without departing from the spirit and scope of the present disclosure as defined by the appended claims and their equivalents.

Although the embodiments are shown and described in the present disclosure as above, the present disclosure is not limited to the above-described specific embodiments, and may be variously modified by those skilled in the art to which the present disclosure pertains without departing from the gist of the present disclosure as claimed in the accompanying claims. These modifications should also be understood to fall within the scope and spirit of the present disclosure.

## Claims

1. A display module comprising:
a substrate including a first circuit layer including a thin film transistor (TFT) circuit, a second circuit layer for data transmission, and a third circuit layer for power and control signal transmission;
a plurality of light-emitting diodes arranged on the first circuit layer;
a plurality of first-side wirings electrically connecting the first circuit layer disposed on a front surface of the substrate to the second circuit layer disposed on an upper portion of a rear surface of the substrate; and
a plurality of second-side wirings electrically connecting the first circuit layer to the third circuit layer disposed on a lower portion of the rear surface of the substrate,
wherein the second circuit layer is formed into a film shape, and is attached to the rear surface of the substrate to be adjacent to a first end of the substrate, and
the third circuit layer is formed into a film shape, and is attached to the rear surface of the substrate to be adjacent to a second end of the substrate.

2. The module as claimed in claim 1, wherein the second circuit layer includes a plurality of first connection pads electrically connected to one end of the plurality of first-side wirings, and
the third circuit layer includes a plurality of second connection pads electrically connected to one end of the plurality of second-side wirings.

3. The module as claimed in claim 2, wherein the plurality of first-side wirings and the plurality of second-side wirings are each made of silver (Ag) or copper (Cu), and
the plurality of first connection pads and the plurality of second connection pads are each made of copper (Cu) or gold (Au).

4. The module as claimed in claim 2, wherein each of the plurality of first-side wirings and the plurality of second-side wirings has a thickness of 1 µm or more, and
each of the plurality of first connection pads and the plurality of second connection pads has a thickness of 1 µm or more.

5. The module as claimed in claim 2, wherein a distance between adjacent first connection pads among the plurality of first connection pads is smaller than a distance between adjacent first-side wirings among the plurality of first-side wirings, and
a distance between adjacent second connection pads among the plurality of second connection pads is smaller than a distance between adjacent second-side wirings among the plurality of second-side wirings.

6. The module as claimed in claim 2, wherein the second circuit layer further includes a plurality of first test pads, and
the third circuit layer further includes a plurality of second test pads.

7. The module as claimed in claim 6, wherein the plurality of first test pads and the plurality of second test pads are each made of a low-resistance metal.

8. The module as claimed in claim 6, wherein the plurality of first test pads and the plurality of second test pads are each made of copper (Cu).

9. The module as claimed in claim 1, wherein each of the second circuit layer and the third circuit layer includes a flexible film layer, a first insulating layer laminated on the film layer, a metal layer laminated on the first insulating layer, and a second insulating layer laminated on the metal layer, and
the second insulating layer includes a plurality of openings disposed therein that expose a portion of the metal layer.

10. The module as claimed in claim 9, wherein the portion of the metal layer is a fan-out wiring section.

11. The module as claimed in claim 9, wherein the portion of the metal layer is a grounding point.

12. A display module comprising:
a glass substrate;
a first circuit layer disposed on a front surface of the glass substrate and including a thin film transistor (TFT) circuit;
a second circuit layer disposed on an upper portion of a rear surface of glass substrate and electrically connected to the first circuit layer by using a plurality of first-side wirings;
a third circuit layer disposed on a lower portion of the rear surface of the glass substrate and electrically connected to the first circuit layer by using a plurality of second-side wirings; and
a control substrate disposed on the rear surface of the glass substrate, electrically connected to the second circuit layer by a plurality of first flexible substrates, and electrically connected to the third circuit layer by a plurality of second flexible substrates,
wherein each of the second circuit layer and the third circuit layer is formed into a film shape and laminated on the glass substrate by using an adhesive layer applied to the glass substrate.

13. The module as claimed in claim 12, wherein the first circuit layer and the second circuit layer each include a plurality of connection pads electrically connected to both ends of the plurality of first-side wirings,
the first circuit layer and the third circuit layer each include a plurality of connection pads electrically connected to both ends of the plurality of second-side wirings,
the plurality of first-side wirings and the plurality of second-side wirings are each made of silver (Ag) or copper (Cu), and
the plurality of connection pads are each made of copper (Cu) or gold (Au).

14. The module as claimed in claim 12, wherein each of the plurality of first-side wirings and the plurality of second-side wirings has a thickness of 1 µm or more, and
each of the plurality of connection pads has a thickness of 1 µm or more.

15. A manufacturing method for a display module, the method comprising:
forming a first circuit layer including a thin film transistor (TFT) circuit on a first surface of a glass substrate;
attaching a second circuit layer, formed into a film shape, to one side of a second surface of the glass substrate, and attaching a third circuit layer, formed into the film shape, to another side of the second surface of the glass substrate;
depositing a plurality of first-side wirings electrically connecting the first circuit layer to the second circuit layer, and depositing a plurality of second-side wirings electrically connecting the first circuit layer to the third circuit layer;
transferring a plurality of light-emitting diodes onto the first circuit layer;
testing the plurality of light-emitting diodes by using a plurality of test pads respectively disposed on the second circuit layer and the third circuit layer; and
electrically connecting the second circuit layer and the third circuit layer to a control substrate.
